# EUROPÄISCHE PATENTSCHRIFT

(11) **EP 1 088 117 B1**
(45) Veröffentlichungstag und Bekanntmachung des Hinweises auf die Patenterteilung: **25.08.2004**
(21) Anmeldenummer: 99957174.8
(22) Anmeldetag: 18.06.1999
(51) Int. Cl.: C23C 18/20, C25D 5/56

(54) **VERFAHREN ZUM AUFBRINGEN EINER METALLISCHEN SCHICHT AUF EINE POLYMEROBERFLÄCHE EINES WERKSTÜCKES**
METHOD FOR DEPOSITING A METALLIC LAYER ON A POLYMER SURFACE OF A WORKPIECE
PROCEDE PERMETTANT D'APPLIQUER UNE COUCHE METALLIQUE SUR LA SURFACE POLYMERE D'UNE PIECE

(30) Priorität: 19.06.1998 AT 105998
(43) Veröffentlichungstag der Anmeldung: 04.04.2001
(73) Patentinhaber: ATOTECH Deutschland GmbH, 10553 Berlin (DE)
(72) Erfinder: RUMPF, Thomas, A-4810 Gmunden (AT)
(74) Vertreter: Effert, Bressel und Kollegen
(86) Internationale Anmeldenummer: PCT/AT1999/000160
(87) Internationale Veröffentlichungsnummer: WO 1999/067321

(56) Entgegenhaltungen:
- EP-A- 0 478 975
- WO-A-96/12051
- US-A- 3 801 368
- US-A- 4 869 930
- US-A- 5 527 566

## Beschreibung

### Technisches Gebiet

Die Erfindung bezieht sich auf ein Verfahren zum Aufbringen einer metallischen Schicht auf eine Polymeroberfläche eines Werkstückes, auf die nach einer Bekeimung mit einem katalytisch wirksamen Platinmetall bzw. einer Platinmetallverbindung ein Beschichtungsmetall autokatalytisch aus einer wäßrigen Lösung ohne äußere Stromzufuhr abgeschieden wird, bevor auf diese Vorbeschichtung wenigstens eine weitere Schicht, vorzugsweise elektrolytisch unter äußerer Stromzufuhr, aufgebracht wird.

### Stand der Technik

Kunststoffbauteile, die hinsichtlich ihres spezifischen Gewichtes und bezüglich der einfachen Formgebung im Vergleich zu metallischen Bauteilen Vorteile mit sich bringen, werden einerseits wegen ihres äußeren Erscheinungsbildes und anderseits zur Beeinflussung ihrer Oberflächeneigenschaften, insbesondere bezüglich der elektrischen Leitfähigkeit, der mechanischen Eigenschaften oder der chemischen Beständigkeit, metallisiert. Dies bereitet jedoch insbesondere bei Werkstücken mit einer Polymeroberfläche Schwierigkeiten, weil die zu beschichtende Oberfläche eines Werkstückes aus einem Polymer aufwendig vorbehandelt werden muß, bevor die Metallschicht mit einer ausreichenden Haftung elektrolytisch aufgebracht werden kann. Die zu beschichtende Polymeroberfläche wird nämlich zunächst mit Edelmetallen, im allgemeinen Platinmetallen, also Elementen der 8. Nebengruppe des Periodensystems (Ru, Rh, Pd, Os, Ir, Pt), bzw. deren Verbindungen bekeimt, um dann eine Vormetallisierung durch ein autokatalytisches Abscheiden eines Beschichtungsmetalles aus einer wäßrigen Lösung ohne äußere Stromzufuhr durchführen zu können. Die Bekeimung der Polymeroberfläche mit einem Platinmetall erfordert eine naßchemische Vorbehandlung in Beiz- und Aktivierungsbädern, die aus Lösungen starker, häufig konzentrierter Säuren und Laugen sowie giftiger Verbindungen bestehen. So wird beispielsweise die Polymeroberfläche bei einem herkömmlichen Verfahrensablauf nach einer Reinigung mit Alkohol bzw. einem organischen Lösungsmittel in einem Bad aus Chromschwefelsäure bei erhöhter Temperatur vorgebeizt, um dann dem eigentlichen Beizvorgang in Chromschwefelsäure bei erhöhter Temperatur unterworfen zu werden. Nach einer Neutralisation der gebeizten Polymeroberfläche kann nach einer Vorbehandlung mit einer Säure die Polymeroberfläche mit einem Platinmetall aus einer geeigneten Platinmetall-Lösung bekeimt werden. Durch die geschilderte mehrstufige Vorbehandlung der Polymeroberfläche soll eine gute Haftung der Platinrnetallkeime an der Polymeroberfläche als Voraussetzung für eine entsprechende Haftung der Vormetailisierung sichergestellt werden, auf die dann eine dickere metallische Beschichtung in üblicher Weise durch ein elektrolytisches Abscheiden des Beschichtungsmetalles unter äußerer Stromzufuhr erfolgen kann. Nachteilig bei dieser bekannten Metallisierung von Polymeroberflächen ist nicht nur der vergleichsweise große Verfahrensaufwand, sondern auch der Umstand, daß bei der Vorbehandlung der Polymeroberfläche schwermetallhaltige Abwässer anfallen. Außerdem ist im Bereich der Beiz- und Aktivierungsbäder mit giftigen Dämpfen zu rechnen. Darüber hinaus muß mit einem erheblichen Bedarf an Chemikalien, Wasser und Energie gerechnet werden.

In WO 96/12051 A1 ist ein Verfahren zum Aufbringen einer metallischen Schicht auf eine Polyimid-Oberfläche beschrieben, auf die nach einer Bekeimung mit einer Palladiumverbindung ein Beschichtungsmetall, beispielsweise eine Ni/B-Legierung, stromlos aus einer Abscheidelösung abgeschieden wird, bevor auf diese Vorbeschichtung wenigstens eine weitere Schicht, beispielsweise eine Kupferschicht, elektrolytisch aufgebracht wird. Zunächst wird die Polyimid-Oberfläche in einem Niederdruckplasma angeätzt. Das Plasmagas enthält beispielsweise Sauerstoff. Das Gas kann auch eine Sauerstoff enthaltende Verbindung, wie ein Stickoxid (N₂O, NOₓ), ein Sauerstoff/Argon- oder ein Sauerstoff/Stickstoff-Gemisch enthalten.

### Darstellung der Erfindung

Der Erfindung liegt somit die Aufgabe zugrunde, die vorstehenden Mängel zu vermeiden und ein Verfahren zum Aufbringen einer metallischen Schicht auf eine Polymeroberfläche eines Werkstückes der eingangs geschilderten Art so auszugestalten, daß eine Bekeimung der Polymeroberfläche mit Platinmetallen bzw. deren. Verbindungen unter Vermeidung von Beiz- und Aktivierungsbädern mit Lösungen starker Säuren und Laugen gewährleistet werden kann, ohne eine Einbuße an Haftfestigkeit zwischen den Platinmetallkeimen und der Polymeroberfläche in Kauf nehmen zu müssen.

Die Erfindung löst die gestellte Aufgabe dadurch, daß zunächst auf der zu beschichtenden Polymeroberfläche Zentren einer Lewis-Säure oder Lewis-Base durch eine Unterdruck-Plasmabehandlung mit einem auf das eingesetzte Polymer abgestimmten Plasmagas angereichert werden, wobei das Plasmagas Kohlenoxide oder Ammoniak oder eine schwefelhaltige Verbindung oder ein Halogen oder ein Halogenwasserstoff enthält, bevor die Polymeroberfläche mit Hilfe eines weiteren Plasmagases, das ein verdampftes Platinmetall bzw. eine Platinmetallverbindung zur nucleophilen bzw. elektrophilen Reaktion mit den Lewis-Säuren bzw. Lewis-Basen enthält unter Unterdruck mit dem Platinmetall bzw. der Platinmetallverbindung bekeimt wird.

Durch die vorgeschlagene Plasmabehandlung der Polymeroberfläche wird nicht nur in an sich bekannter Weise die Oberflächenspannung des Polymers herabgesetzt und eine gute Benetzbarkeit der zu beschichtenden Werkstückoberfläche erreicht, sondern auch eine chemische Reaktion im Oberflächenbereich ausgelöst, indem sich je nach eingesetztem Plasmagas Zentren von Lewis-Säuren oder Lewis-Basen bilden. Die damit verbundene Polarisierung der Polymeroberfläche ist eine wesentliche Voraussetzung für eine haftfeste Verbindung zwischen der Polymeroberfläche und den Metallionen. Da in ihrer Stärke einander entsprechende Lewis-Säuren und Lewis-Basen bevorzugt miteinander reagieren, wird die mit Zentren einer Lewis-Säure oder Lewis-Base überzogene Polymeroberfläche in einem weiteren Behandlungsschritt einer Plasmabehandlung mit einem verdampften Platinmetall bzw. einer Platinmetallverbindung unterworfen, wobei dieses Plasmagas eine entsprechende Lewis-Base bzw. Lewis-Säure darstellt, so daß sich nucleoohile bzw. elektrophile Reaktionen mit der Wirkung ergeben, daß die Platinmetallatome bzw. die Moleküle der Platinmetallverbindung fest an die Polymeroberfläche gebunden werden, ohne ihre katalytische Wirksamkeit für die anschließende stromlose, elektrolytische Vormetallisierung zu verlieren.

Zur Bildung der Lewis-Säuren oder Lewis-Basen auf der Polymeroberfläche können unter Berücksichtigung des jeweils zu beschichtenden Polymers unterschiedliche Gase eingesetzt werden. Um in vorteilhafter Weise Zentren von Lewis-Basen bzw. Lewis-Säuren auf der Polymeroberfläche zu erhalten, kann das eingesetzte Plasmagas Kohlenoxide (CO, CO₂) enthalten. Durch den Sauerstoff des Plasmagases werden die Polymermoleküle an der Oberfläche teilweise so anoxidiert, daß neue Hydroxi-, Carbonyl-und Carboxygruppen gebildet werden, die durch ihre Polarität eine starke Affinität zu den Metallionen der nachfolgenden Plasmabehandlung aufweisen.

Eine andere vorteilhafte Möglichkeit, die Polymeroberfläche zu polarisieren, besteht darin, ein Plasmagas mit einer schwefelhaltigen Verbindung zur Bildung der Lewis-Säuren oder Lewis-Basen einzusetzen. Solche schwefelhaltigen Verbindungen, wie Schwefeloxide (SO₂, SO₃), Schwefelfluoride (SF₆) oder Schwefelwasserstoff (H₂S), führen bei der Plasmaanregung je nach Art des Polymers zu einer Sulfonierung von z. B. Aromaten und damit zur-gewünschten Polarisierung der Polymeroberfläche. Ebenso können andere Gase eingesetzt werden, die mit der Polymeroberfläche reagieren, nämlich (NH₃) oder Halogene oder Halogenwasserstoffe.

Durch die zweistufige Plasmabehandlung, die nacheinander im selben Behandlungsgefäß, aber auch in voneinander getrennten Behandlungsgefäßen durchgeführt werden kann, entfallen somit die aufwendigen naßchemischen Vorbehandiungen in Beiz- und Aktivierungsbädern, so daß auch die mit diesen naßchemischen Vorbehandlungen verbundenen Nachteile entfallen. Trotzdem wird eine gute Haftfestigkeit zwischen den Platinmetallen und der Polymeroberfläche als Voraussetzung dafür erreicht, daß eine dauerhafte Metallisierung der Polymeroberfläche gewährleistet werden kann. Die Vormetallisierung kann in herkömmlicher Weise durchgeführt werden, indem das zur Vorbeschichtung vorgesehene Metall aus einem wäßrigen Elektrolyten autokatalytisch ohne äußere Stromzufuhr auf der mit Platinmetallen bekeimten Polymeroberfläche abgeschieden wird. Die Schichtdicke dieser autokatalytischen Schicht wird so gewählt, daß sie möglichst dünn, aber ausreichend porenfrei ausfällt, so daß es bei der nachfolgenden galvanischen Abscheidung der eigentlichen Metallschicht zu keinen Störungen kommt. Die Schichtdicke der autokatalytisch abgeschiedenen Metallschicht beträgt ca. 0,2 - 2 µm vorzugsweise 1 µm Auf diese Vorbeschichtung kann dann eine dickere Metallbeschichtung in der jeweils geforderten Stärke galvanisch unter äußerer Stromzufuhr abgeschieden werden. Es ist aber auch möglich, auf die Vorbeschichtung Schichten mit anderen Beschichtungsverfahren aufzubringen, wenn diese Schichten beispielsweise eine galvanische Abscheidung nicht zulassen bzw. diese nicht erwünscht ist.

### Bester Weg zur Ausführung der Erfindung

Im nachfolgenden Ausführungsbeispiel wurde ein quadratisches Polymerplättchen mit einer Seitenlänge von 80 mm und einer Dicke von 5 mm nach einer üblichen Vorreinigung in einen an eine Vakuumpumpe angeschlossenen Behandlungsbehälter eingebracht, aus dem die Luft bis zu einem Unterdruck von 0,1 mbar abgesaugt wurde, bevor zur Polarisierung der Polymeroberfläche in den Behandlungsbehälter ein Plasmagas eingeleitet wurde, das bei einem Behandlungsdruck zwischen 5 und 10 mbar zur Zündung des Plasmas mit Hochfrequenz angeregt wurde. Während einer vorgegebenen Behandlungszeit wurde die Polymeroberfläche durch entsprechende Reaktionen mit dem Plasmagas partiell chemisch umgesetzt, so daß Zentren von Lewis-Säuren bzw. - Basen entstanden. Nach dieser Behandlung der Polymerplättchen wurde das Plasmagas bei einem Unterdruck von 0,1 mbar abgezogen, bevor ein weiteres Plasmagas unter Verdampfung einer Platinmetallverbindung bei einem Druck von 1 mbar zugeführt wurde. Bei einem zwischen 1 und 5 mbar eingestellten Behandlungsdruck wurde das Plasma wieder durch äußere Anregung mit Radiofrequenz gezündet, so daß die Zentren von Lewis-Säuren bzw. -Basen auf der Polymeroberfläche mit den Platinmetallverbindungen während der nachfolgenden Behandlungszeit reagieren konnten, die ja Eigenschaften von Lewis-Basen bzw. -Säuren aufweisen. Nach einer Belüftung des Behandlungsbehälters wurde das an seiner Oberfläche mit einer Platinmetallverbindung bekeimte Polymerplättchen aus dem Behandlungsbehälter entnommen und in einen autokatalytisch arbeitenden Elektrolyten ohne äußere Stromzufuhr mit einer metallischen Vorbeschichtung versehen, die eine Schichtdicke von ca. 1 µm aufwies. Auf diese metallische Vorbeschichtung konnten dann in herkömmlicher Weise unterschiedliche Schichten aufgebracht werden, wobei zufolge der guten Haftung der Platinmetallverbindungen auf der Polymeroberfläche eine insgesamt hervorragende Haftung aller Schichten erzielt werden konnte.

### Ausführungsbeispiel

Ein Kunststoffplättchen aus Polyetherimid wurde unter entsprechenden Bedingungen einer Behandlung mit einem Plasmagas aus Stickstoff mit 20 Vol.% Schwefelwasserstoff ausgesetzt, was zu Zentren schwacher Lewis-Basen auf der Polymeroberfläche führte (Behandlungszeit 180 s). Zur Bildung schwacher Lewis-Säuren wurde Allylpalladiumchlorid in einem Trägergas aus Argon, dem Ammoniak zudotiert wurde, verdampft, und zur weiteren Plasmabehandlung des Kunststoffplättchens während einer Behandlungszeit von 120 s eingesetzt Die Vorbeschichtung erfolgte stromlos mit Kupfer. Die eigentliche Metallisierung wurde durch ein galvanisches Abscheiden von Glanzkupfer unter äußerer Stromzufuhr in einer Schichtdicke von 50 µm erreicht Statt einer solchen galvanisch abgeschiedenen Schicht könnte aber auch eine Schicht physikalisch im Vakuum aufgetragen werden, beispielsweise eine Hartstoffschicht aus Titannitrid (Schichtdicke z. B. 1µm).

## Patentansprüche

1. Verfahren zum Aufbringen einer metallischen Schicht auf eine Polymeroberfläche eines Werkstückes, auf die nach einer Bekeimung mit einem katalytisch wirksamen Platinmetall bzw. einer Platinmetallverbindung ein Beschichtungsmetall autokatalytisch aus einer wässrigen Lösung ohne äußere Stromzufuhr abgeschieden wird, bevor auf diese Vorbeschichtung wenigstens eine weitere Schicht, vorzugsweise elektrolytisch unter äußerer Stromzufuhr, aufgebracht wird,
**dadurch gekennzeichnet, dass** zunächst auf der zu beschichtenden Polymeroberfläche Zentren einer Lewis-Säure oder Lewis-Base durch eine Unterdruck-Plasmabehandlung mit einem auf das eingesetzte Polymer abgestimmten Plasmagas angereichert werden, bevor die Polymeroberfläche mit Hilfe eines weiteren Plasmagases, das ein verdampftes Platinmetall bzw. eine Platinmetallverbindung zur nukleophilen bzw. elektrophilen Reaktion mit den Lewis-Säuren bzw. Lewis-Basen enthält, unter Unterdruck mit dem Platinmetall bzw. der Platinmetallverbindung bekeimt wird, wobei das zur Bildung der Lewis-Säuren oder Lewis-Basen auf der Polymeroberfläche eingesetzte Plasmagas Kohlenoxide oder Ammoniak oder eine schwefelhaltige Verbindung oder ein Halogen oder ein Halogenwasserstoff enthält.

## Claims

1. Method for applying a metal film to a polymer surface of a workpiece, onto which surface, after nucleation with a catalytically active platinum metal or a platinum metal compound, a coating metal is auto-catalytically precipitated from an aqueous solution without any external current supply, before at least one further layer is applied to this preliminary coating, preferably electrolytically with an external current supply,
**characterised in that** centres of a Lewis acid or Lewis base are enriched initially on the polymer surface to be coated by a vacuum plasma treatment using a plasma gas matched to the polymer used, before the polymer surface is nucleated under vacuum with the platinum metal or the platinum metal compound with the aid of a further plasma gas which contains an evaporated platinum metal or a platinum metal compound for nucleophilic or electrophilic reaction with the Lewis acids or Lewis bases, the plasma gas used to form the Lewis acids or Lewis bases on the polymer surface containing carbon oxides or ammonia or a sulphurous compound or a halogen or a hydrohalogen.

## Revendications

1. Procédé pour appliquer une couche métallique sur une surface polymère d'une pièce, sur laquelle un métal de plaquage est déposé par autocatalyse à partir d'une solution aqueuse sans apport de courant extérieur après une germination avec un métal catalytiquement efficace de la famille de platine ou un composé de ce métal avant qu'au moins une autre couche soit déposée sur ce plaquage préalable, de préférence de manière électrolytique avec un apport de courant extérieur, **caractérisé en ce que**, tout d'abord sur la surface polymère à recouvrir, les centres d'un acide de Lewis ou d'une base de Lewis sont enrichis par un traitement plasma sous vide avec un gaz plasma adapté au polymère introduit, avant que la surface polymère germine sous vide avec le métal de la famille de platine ou le composé de ce métal, à l'aide d'un gaz plasma, qui contient un métal de la famille de platine vaporisé ou un composé de ce métal à des fins de réaction nucléophile ou électrophile avec les acides de Lewis ou les bases de Lewis, le gaz plasma introduit pour la formation des acides de Lewis ou des bases de Lewis sur la surface polymère contenant des oxydes de carbone ou de l'ammoniac ou un composé soufré ou un halogène ou un halogénure d'hydrogène.
